# EUROPEAN PATENT APPLICATION

(11) **EP 4 729 652 A2**
(43) Date of publication of application: **22.04.2026**
(21) Application number: 25204569.5
(22) Date of filing: 25.09.2025
(51) Int. Cl.: C23C 16/04, C23C 16/08, C23C 16/455, H10P 14/43, H10P 14/60

(54) **METHOD OF PROCESSING SUBSTRATE, METHOD OF MANUFACTURING SEMICONDUCTOR DEVICE, SUBSTRATE PROCESSING APPARATUS, AND PROGRAM**

(30) Priority: 17.10.2024 JP 2024182141
(71) Applicant: Kokusai Electric Corporation, Tokyo 101-0045 (JP)
(72) Inventor: KAGA, Yukinao, Toyama-shi, Toyama 939-2393 (JP); KURIBAYASHI, Koei, Toyama-shi, Toyama 939-2393 (JP); BANNAE, Yuki, Toyama-shi, Toyama 939-2393 (JP)
(74) Representative: Bardehle Pagenberg Partnerschaft mbB Patentanwälte Rechtsanwälte

(57) **Abstract**

A technique includes: performing a film formation operation of forming a film containing a metal element on a first surface preferentially over a second surface of a substrate, the act of performing the film formation operation including: (a) forming metal-containing substance containing metal element on at least a portion of the substrate by performing: (a1) supplying a first gas containing the metal element to the substrate including the first surface as a surface of first substance and the second surface as a surface of second substance; and (a2) supplying a second gas containing the metal element to the substrate; and (b) supplying a reaction gas to the substrate, wherein (a) includes a period TC during which (a1) and (a2) are performed simultaneously, wherein the first gas etches the metal-containing substance at a first rate, and wherein the second gas etches the metal-containing substance at a second rate.

## Description

### CROSS-REFERENCE TO RELATED APPLICATION

This application is based upon and claims the benefit of priority from Japanese Patent Application No. 2024-182141, filed on October 17, 2024, the entire contents of which are incorporated herein by reference.

### TECHNICAL FIELD

The present disclosure relates to a method of processing a substrate, a method of manufacturing a semiconductor device, a substrate processing apparatus, and a program.

### BACKGROUND

As a process of manufacturing a semiconductor device or a process of processing a substrate in the related art, a film may be formed on a certain surface preferentially over another surface, that is, a selective film formation may be performed.

### SUMMARY

The present disclosure provides a technique capable of efficiently performing selective film formation.

According to one embodiment of the present disclosure, there is provided a technique, which includes: performing a film formation operation of forming a film containing a metal element on a first surface preferentially over a second surface of a substrate, the act of performing the film formation operation including: (a) forming a metal-containing substance that contains the metal element on at least a portion of the substrate by performing: (a1) supplying a first gas containing the metal element to the substrate including the first surface that is a surface of a first substance and the second surface that is a surface of a second substance different from the first substance; and (a2) supplying a second gas containing the metal element to the substrate; and (b) supplying a reaction gas to the substrate, wherein (a) includes a period TC during which (a1) and (a2) are performed simultaneously, wherein the first gas etches the metal-containing substance at a first rate, and wherein the second gas etches the metal-containing substance at a second rate higher than the first rate.

### BRIEF DESCRIPTION OF DRAWINGS

The accompanying drawings, which are incorporated in and constitute a part of the specification, illustrate embodiments of the present disclosure.
FIG. 1 is a vertical cross-sectional view schematically illustrating a vertical process furnace of a substrate processing apparatus according to some embodiments of the present disclosure.
FIG. 2 is a schematic configuration diagram of a controller in a substrate processing apparatus according to some embodiment of the present disclosure, illustrating a control system of the controller in a block diagram.
FIG. 3 is a diagram illustrating a film formation process according to some embodiments of the present disclosure.
FIG. 4A is a diagram illustrating a substrate including a recess. FIG. 4B is a diagram illustrating a state where a film is formed within the recess on the substrate. FIG. 4C is a diagram illustrating a state where the recess on the substrate is filled with the film.
FIG. 5A is a diagram illustrating a modification of a film formation process according to some embodiments of the present disclosure. FIG. 5B is a diagram illustrating a modification of a film formation process according to some embodiments of the present disclosure.
FIG. 6 is a diagram illustrating a modification of a film formation process according to some embodiments of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

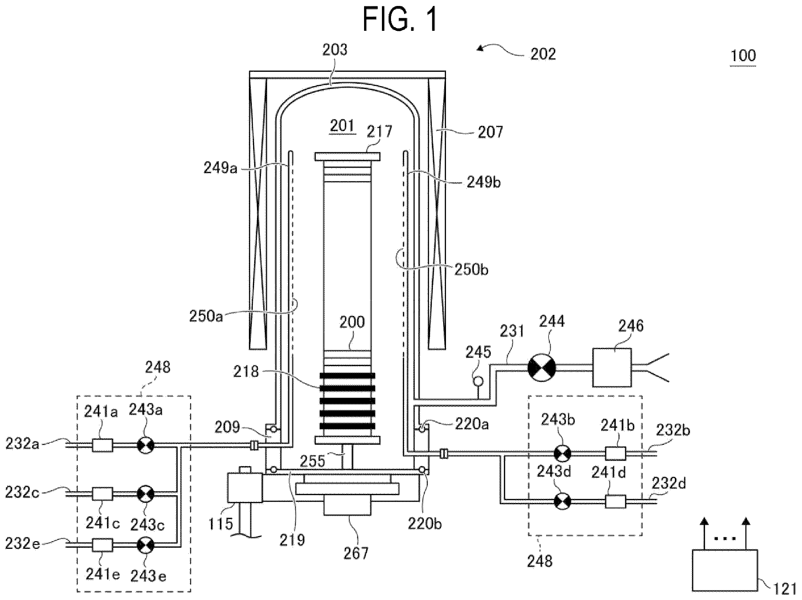

Hereinafter, some embodiments of the present disclosure will be described mainly with reference to FIGS. 1 to 4C. In addition, the drawings used in the following description are schematic, and dimensional relationships, proportions, and the like of the respective elements illustrated in the drawings may not match actual ones. Further, dimensional relationships, proportions, and the like of the respective elements may not match one another among multiple drawings.

### (1) Configuration of Substrate Processing Apparatus

As illustrated in FIG. 1, a process furnace 202 includes a heater 207 as a heating system (temperature adjuster). The heater 207 also functions as an activator (exciter) configured to activate (excite) gases with heat.

A reaction tube 203 is arranged inside the heater 207. The reaction tube 203 is made of a heat-resistant material such as quartz (SiO₂) or silicon carbide (SiC), and is formed in a cylindrical shape with a closed upper end and an open lower end. A manifold 209 is arranged below the reaction tube 203 to support the reaction tube 203. An O-ring 220a is installed as a seal between the manifold 209 and the reaction tube 203. A process container (reaction container) is mainly constituted by the reaction tube 203 and the manifold 209. A process chamber 201 configured to be capable of accommodating one or more wafers 200 as substrates is formed in the interior of the process container.

Nozzles 249a and 249b are installed within the process chamber 201 so as to penetrate a sidewall of the manifold 209. Gas supply pipes (piping) 232a and 232b are connected to the nozzles 249a and 249b, respectively.

At the gas supply pipes 232a and 232b, mass flow controllers (MFCs) 241a and 241b, which serve as flow rate controllers (flow rate control parts), and valves 243a and 243b, which serve as opening/closing valves, are installed in this order from the upstream side, respectively. Gas supply pipes 232C and 232e are connected to the gas supply pipe 232a at the downstream side of the valve 243a. A gas supply pipe 232d is connected to the gas supply pipe 232b at the downstream side of the valve 243b. At the gas supply pipes 232C, 232d, and 232e, MFCs 241C, 241d, and 241e and valves 243C, 243d and 243e are installed in this order from the upstream side, respectively.

The nozzles 249a and 249b are installed in an annular space between an inner wall of the reaction tube 203 and the wafers 200 in a plan view so as to extend upward in a stacking direction of the wafers 200 from a lower side to an upper side of the inner wall of the reaction tube 203. Gas supply holes 250a and 250b configured to supply gases are respectively installed in the side surfaces of the nozzles 249a and 249b. The gas supply holes 250a and 250b are open to face a center of the reaction tube 203, respectively, which enables supply of gases toward the wafers 200. A plurality of gas supply holes 250a and 250b are formed from the lower side to the upper side of the reaction tube 203.

A first gas, which serves as a precursor gas and contains a metal element X, is supplied from the gas supply pipe 232a into the process chamber 201 via the MFC 241a, valve 243a, and nozzle 249a.

A second gas, which serves as the precursor gas and contains the metal element X, is supplied from the gas supply pipe 232C into the process chamber 201 via the MFC 241C, valve 243C, and nozzle 249a.

A reaction gas, which reacts with the precursor gas, is supplied from the gas supply pipe 232b into the process chamber 201 via the MFC 241b, valve 243b, and nozzle 249b.

An inert gas is supplied from the gas supply pipes 232d and 232e into the process chamber 201 via the MFCs 241d and 241e, valves 243d and 243e, gas supply pipes 232b and 232a, and nozzles 249b and 249a, respectively.

A first gas supply system is mainly constituted by the gas supply pipe 232a, MFC 241a, and valve 243a. A second gas supply system is mainly constituted by the gas supply pipe 232C, MFC 241C, and valve 243C. The first gas supply system and the second gas supply system may collectively be referred to as a precursor gas supply system or a metal-containing gas (containing the metal element X) supply system. A reaction gas supply system is mainly constituted by the gas supply pipe 232b, MFC 241b, and valve 243b. The first gas supply system, the second gas supply system, and the reaction gas supply system may collectively be referred to as a gas supply system. Further, an inert gas supply system is mainly constituted by the gas supply pipes 232d and 232e, MFCs 241d and 241e, and valves 243d and 243e. The inert gas supply system may be included in the gas supply system.

Any one or the entirety of the various supply systems described above may be constituted as an integrated supply system 248 in which the valves 243a to 243e, MFCs 241a to 241e, and others are integrated. The integrated supply system 248 is connected to each of the gas supply pipes 232a to 232e, and is configured to control, by a controller 121 to be described later, supply operations of various gases into the gas supply pipes 232a to 232e, that is, opening/closing operations of the valves 243a to 243e and flow rate regulating operations by the MFCs 241a to 241e.

At the reaction tube 203, an exhaust pipe 231 configured to exhaust an internal atmosphere of the process chamber 201 is installed. The exhaust pipe 231 is connected to a vacuum pump 246, which serves as a vacuum exhauster, via a pressure sensor 245, which serves as a pressure detector (a pressure detection part) configured to detect an internal pressure of the process chamber 201, and an auto pressure controller (APC) valve 244, which serves as a pressure regulator (a pressure regulating part). The APC valve 244 is configured to be capable of performing or stopping vacuum exhaust in the process chamber 201 by being opened or closed while the vacuum pump 246 is in operation. The APC valve 244 is further configured to be capable of regulating the internal pressure of the process chamber 201 by adjusting a degree of valve opening based on pressure information detected by the pressure sensor 245 while the vacuum pump 246 is in operation. An exhaust system is mainly constituted by the exhaust pipe 231, APC valve 244, and pressure sensor 245. The vacuum pump 246 may also be included in the exhaust system.

A seal cap 219 is installed below the manifold 209 and serves as a furnace opening lid configured to be capable of airtightly closing a lower end opening of the manifold 209. An O-ring 220b is installed on an upper surface of the seal cap 219 and serves as a seal making contact with the lower end of the manifold 209. A rotator 267 configured to rotate a boat 217 to be described later is installed below the seal cap 219. A rotating shaft 255 of the rotator 267 passes through the seal cap 219 and is connected to the boat 217. A boat elevator 115 is configured to raise or lower the seal cap 219, thereby enabling loading or unloading of the boat 217 into or out of the process chamber 201. The boat elevator 115 is constituted as a transfer apparatus (transfer mechanism) configured to transfer the boat 217, i.e., the wafers 200, into or out of the process chamber 201.

The boat 217, which serves as a substrate support, is configured to support a plurality of wafers 200, e.g., 25 to 200 wafers in such a state that the wafers 200 are arranged at intervals in a horizontal posture and in multiple stages along the vertical direction with the centers of the wafers 200 aligned with one another. The boat 217 is made of, for example, a heat-resistant material such as quartz or SiC. Heat-insulating plates 218, which are made of, for example, a heat-resistant material such as quartz or SiC, are supported in multiple stages in a lower region of the boat 217. In addition, notation of numerical ranges such as "25 to 200" in the present disclosure means that both lower and upper limits are included in that range. Thus, for example, "25 to 200" means "25 or more and 200 or less." The same applies to other numerical ranges.

A temperature sensor 263 is installed as a temperature detector within the reaction tube 203. The internal temperature of the process chamber 201 falls within a desired temperature distribution by adjusting a state of supplying an electric power to the heater 207 based on temperature information detected by the temperature sensor 263. The temperature sensor 263 is formed in an L-shape and is installed along the inner wall of the reaction tube 203.

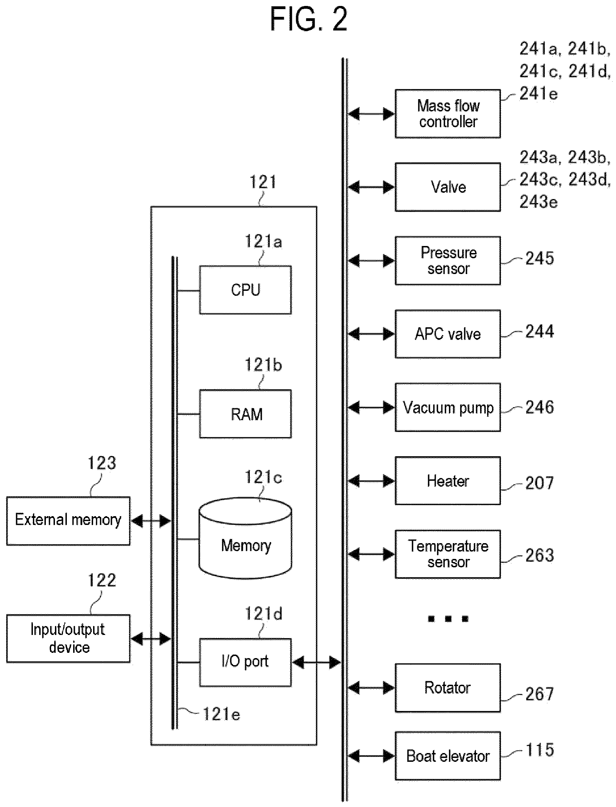

As illustrated in FIG. 2, the controller 121, which is a control part (control means or unit), is constituted as a computer including a central processing unit (CPU) 121a, a random access memory (RAM) 121b, a memory 121C, and an I/O port 121d. The RAM 121b, memory 121C, and I/O port 121d are configured to be capable of exchanging data with the CPU 121a via an internal bus 121e. The controller 121 is connected to an input/output device 122, which is constituted as, for example, a touch panel. In addition, the substrate processing apparatus may be configured to include a single controller, or may be configured to include a plurality of controllers. In other words, control to perform a processing sequence to be described later may be performed by using a single controller, or may be performed by using a plurality of controllers. Further, the plurality of controllers may be constituted as a control system in which the plurality of controllers are connected to each other via a wired or wireless communication network, and the entire control system may perform control to perform the processing sequence which is described below. When the term "controller" is used in the present disclosure, it may include a plurality of controllers or a control system constituted by a plurality of controllers, as well as one controller.

The memory 121C is constituted by, for example, a flash memory, hard disk drive (HDD), and others. The memory 121C stores, in a readable manner, a control program that controls the operation of a substrate processing apparatus 100, a process recipe containing procedures, conditions and others of substrate processing to be described later, and others. The process recipe functions as a program that is combined to cause the controller 121 to execute each sequence in a substrate processing process to be described later, to obtain an expected result. Hereinafter, the process recipe and the control program may be generally and simply referred to as a "program (program product)." Further, the process recipe may be simply referred to as a "recipe." When the term "program" is used herein, it may indicate a case of including the recipe, a case of including the control program, or a case of including both the recipe and the control program. The RAM 121b is constituted as a memory area (work area) in which programs or data read by the CPU 121a are temporarily stored.

The I/O port 121d includes the aforementioned MFCs 241a to 241e, valves 243a to 243e, pressure sensor 245, APC valve 244, vacuum pump 246, heater 207, temperature sensor 263, rotator 267, boat elevator 115, and others.

The CPU 121a is configured to read and execute the control program from the memory 121C and read the recipe from the memory 121C in response to an input such as an operation command from the input/output device 122. The CPU 121a is configured to control the flow rate regulating operation of various gases by the MFCs 241a to 241e, the opening/closing operation of the valves 243a to 243e, the opening/closing operation of the APC valve 244, the pressure regulating operation by the APC valve 244 based on the pressure sensor 245, the actuating and stopping operation of the vacuum pump 246, the temperature regulating operation of the heater 207 based on the temperature sensor 263, the operation of rotating the boat 217 and adjusting the rotational speed of the boat 217 by the rotator 267, the operation of raising or lowering the boat 217 by the boat elevator 115, and others, according to contents of the read recipe.

The controller 121 may be configured by installing, on the computer, the above-described program stored in an external memory (e.g., a magnetic disk such as a hard disk, an optical disk such as a CD, and a semiconductor memory such as a USB memory) 123. The memory 121C or the external memory 123 is constituted as a computer-readable recording medium storing the program. Hereinafter, these are generally and simply referred to simply as "recording medium." The term "recording medium" as used herein may indicate a case of including the memory 121C, a case of including the external memory 123, or a case of including both the memory 121C and the external memory 123. In addition, the programs may be provided to the computer by using communication means or unit such as the Internet or a dedicated line, instead of using the external memory 123.

### (2) Substrate Processing Process

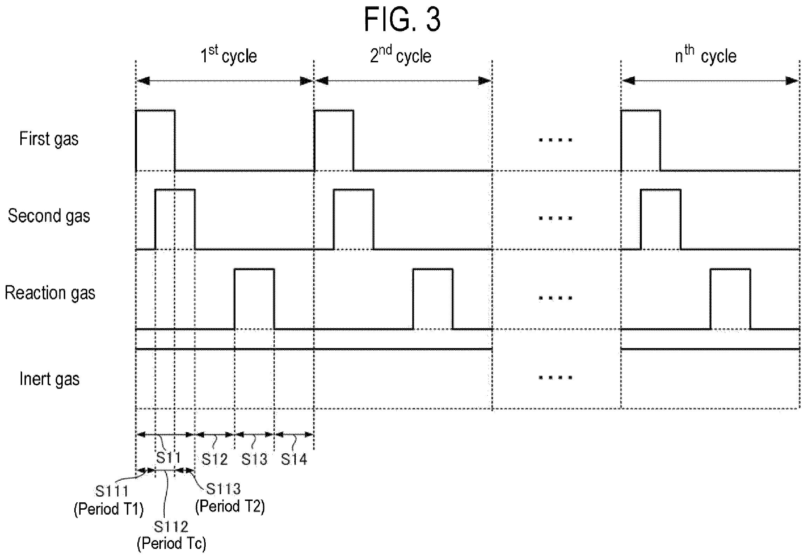

An example of a processing sequence to form a film 500 containing a metal element X on a first surface 300, which is a surface of a first substance, of the wafer 200 including the first surface 300 and a second surface 400, which is a surface of a second substance, as a step of a substrate processing process in the manufacture of a semiconductor device, by using the above-described substrate processing apparatus 100 will be described with reference to FIGS. 3 to 4C. In the following description, an operation of each component constituting the substrate processing apparatus 100 is controlled by the controller 121.

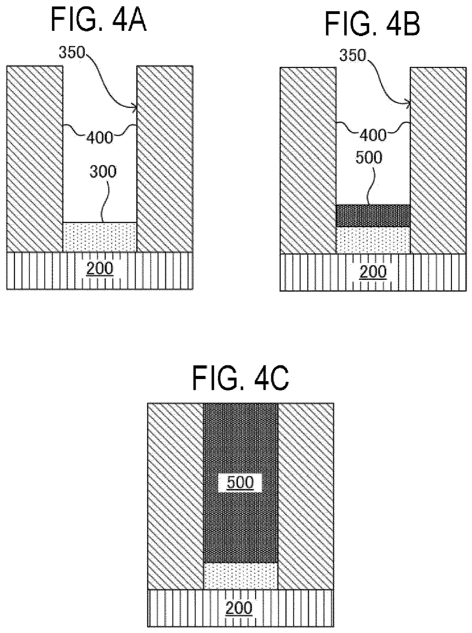

As illustrated in FIG. 4A, a recess 350 with the first surface 300 formed on a bottom and the second surface 400 formed on a sidewall thereof is formed on the surface of the wafer 200. In the following substrate processing process, the film 500 containing the metal element X is selectively formed on the first surface 300 within the recess 350 to fill the recess 350. In other words, in the embodiments of the present disclosure, the film 500 containing the metal element X is formed on the first surface 300 within the recess 350 of the wafer 200, which includes the first surface 300 and the second surface 400, preferentially (or selectively) over the second surface 400. In this case, the expression "forming a film on the first surface 300 preferentially (selectively) over the second surface 400" as used herein includes a case where no film is formed on the second surface 400 and a case where a film is formed on the second surface 400 with a thickness relatively smaller than that of the film formed on the first surface 300.

In this case, the first substance and the second substance are different from each other. Specifically, the first substance is constituted by a conductive substance and forms a so-called conductive film with high electrical conductivity. The first surface 300 of the first substance is, for example, a molybdenum (Mo) film or a titanium nitride (TiN) film. The second substance of the second surface 400 is constituted by a non-conductive substance and forms a film with lower electrical conductivity than the first surface 300. The second surface 400 is, for example, an oxide film such as a silicon oxide (SiO) film or a semiconductor film.

The term "wafer" as used herein may refer to the wafer itself, or a stack including the wafer and a predetermined layer or film formed on the surface of the wafer. The term "surface of the wafer" as used herein may refer to the surface of the wafer itself, or a surface of a predetermined layer or film formed on the wafer. The expression "forming a predetermined layer on the wafer" as used herein may refer to "forming a predetermined layer directly on the surface of the wafer itself" or "forming a predetermined layer on a layer or film that is formed on the wafer." The term "substrate" as used herein is synonymous with the term "wafer".

### (Wafer Loading)

When the plurality of wafers 200 are loaded (wafer-charged) into the boat 217, as illustrated in FIG. 1, the boat 217 supporting the plurality of wafers 200 is raised by the boat elevator 115, and is loaded into the process chamber 201 (boat loading) and accommodated within the process container. In this state, the seal cap 219 seals the lower end opening of the manifold 209 via the O-ring 220b.

### (Pressure Regulation and Temperature Regulation)

The interior of the process chamber 201, i.e., a space where the wafers 200 are present is vacuum-exhausted to reach a desired pressure (degree of vacuum) by the vacuum pump 246. At this time, the internal pressure of the process chamber 201 is measured by the pressure sensor 245, and the APC valve 244 is feedback-controlled based on the measured pressure information (pressure regulation). The vacuum pump 246 is maintained in a constantly operated state at least until the wafers 200 are completely processed. Further, the interior of the process chamber 201 is heated to reach a desired temperature by the heater 207. At this time, a state of supplying electric power to the heater 207 is feedback-controlled based on the temperature information detected by the temperature sensor 263 such that a temperature distribution in the process chamber 201 becomes a desired temperature distribution (temperature regulation). The heating of the interior of the process chamber 201 by the heater 207 continues at least until the wafers 200 are completely processed.

### (Film Formation Step)

In the film formation step, steps S11 to S14 are performed a predetermined number of times.

### (Precursor Gas Supply, Step S11)

### ((First Gas Supply, Step S111))

First, a first gas containing the metal element X is supplied to the wafer 200 within the process chamber 201. Specifically, the valve 243a is opened to flow the first gas through the gas supply pipe 232a. A flow rate of the first gas is regulated by the MFC 241a, and the first gas is supplied into the process chamber 201 via the nozzle 249a, and exhausted via the exhaust pipe 231. At this time, the valve 243e is simultaneously opened to allow the inert gas to flow through the gas supply pipe 232e. A flow rate of the inert gas is regulated by the MFC 241e, and the inert gas is supplied, along with the first gas, into the process chamber 201, and exhausted via the exhaust pipe 231. Further, to prevent the first gas from entering the nozzle 249b, the valve 243d is opened to allow the inert gas to flow through the gas supply pipe 232d. The inert gas is supplied into the process chamber 201 via the gas supply pipe 232d and the nozzle 249b, and is exhausted via the exhaust pipe 231. At this time, a main gas flowing through the process chamber 201 is the first gas.

Processing conditions in step S111 are exemplified as follows:
Supply time of first gas (period T1): 0.01 to 60 seconds, specifically 2 to 20 seconds;
Processing pressure: 10 to 13 300 Pa, specifically, 20 to 1,330 Pa;
Supply flow rate of first gas: 0.01 to 1 slm, specifically, 0.2 to 0.9 slm; and
Supply flow rate of inert gas: 0.02 to 2 slm, specifically 0.4 to 1.8 slm.

In addition, the processing temperature may be substantially the same in any one of the following steps. Further, the processing temperature herein refers to the temperature of the wafer 200 or the internal temperature of the process chamber 201, and the processing pressure herein refers to the internal pressure of the process chamber 201. Further, a processing time refers to a time during which a processing continues. The same applies to the following description.

Through the supply of the first gas, a metal-containing substance Y that contains the metal element X is formed on at least a portion of the wafer 200. In this case, the metal-containing substance Y is at least one selected from the group of a molecule of the first gas or the second gas chemically adsorbed or physically adsorbed on the surface of the wafer 200, a part of a molecular structure of the first gas or the second gas and containing the metal element X, a compound containing the metal element X chemically bonded with another element, and a simple substance of the reduced metal element X. Specifically, for example, the metal-containing substance Y is a molecule of a Mo-containing gas, a part of a molecular structure of a Mo-containing gas, or Mo.

In this case, the first gas forms the metal-containing substance Y on the wafer 200. Further, the first gas has a property of etching (also referred to as removing) the metal-containing substance Y on the wafer 200 at a first rate which is lower than an etching rate of the second gas to be described later. Further, the first gas may form the metal-containing substance Y on the wafer 200 at a film formation rate higher than that of the second gas. In other words, it may be said that the first gas is a gas that is more likely to form the metal-containing substance Y on the wafer 200 and is less likely to remove the metal-containing substance Y on the wafer 200. In this step, the metal-containing substance Y is formed at a high film formation rate by the supply of the first gas, and the metal-containing substance Y formed on the wafer 200 is etched (removed) at an etching rate lower than that of the second gas.

As the first gas and the second gas to be described later, a gas that forms and etches the metal-containing substance Y on the wafer 200 may be used. Examples of such a gas may include a gas containing the metal element X and a halogen element. Further, a gas containing the metal element X, halogen element, and oxygen (O), or a gas containing the metal element X and halogen element but no O may be used as the first gas and the second gas to be described later. It may be more difficult for the gas containing the metal element X, halogen element, and O to etch the metal-containing substance Y than the gas containing the metal element X and halogen element but no O.

Examples of the metal element X may include metal elements of groups 3 to 14 and periods 4 to 6. The metal element X may be a transition metal element. In this case, the effects in the embodiments of the present disclosure may be more obtained. Further, the metal element X may be a transition metal element of the fifth period. In this case, the effects in the embodiments of the present disclosure may be more obtained. For example, Mo may be used as a transition metal element of the fifth period. In this case, it may become particularly easier to obtain the effects in the embodiments of the present disclosure.

Examples of the halogen element may include chlorine (Cl), fluorine (F), bromine (Br), and iodine (I). One or more of these may be used as the halogen element.

Specifically, for example, a gas containing Mo, Cl, and O may be used as the first gas. For example, a gas including any one of a molybdenum dichloride dioxide (MoO₂Cl₂) gas and a molybdenum oxytetrachloride (MoOCl₄) gas, or a gas including one or more of these gases may be used as the gas containing Mo, Cl, and O.

Further, when using, as the first gas, a gas containing Cl and O and a transition metal element of the fifth period with an electron orbit similar to that of Mo, it is easy to obtain the same effects as when using the gas containing Mo, Cl, and O. Examples of the transition metal element of the fifth period may include yttrium (Y), zirconium (Zr), niobium (Nb), technetium (TC), ruthenium (Ru), rhodium (Rh), palladium (Pd), silver (Ag), and cadmium (Cd).

Examples of the inert gas may include noble gases such as an argon (Ar) gas, a helium (He) gas, a neon (Ne) gas, and a xenon (Xe) gas, as well as a nitrogen (N₂) gas. One or more of these gases may be used as the inert gas.

### ((Simultaneous Supply of First and Second Gases, step S112))

After step S111, the supply of the second gas containing the metal element X starts while continuing the supply of the first gas. That is, the supply of the second gas starts after the start of the supply of the first gas. Specifically, while continuing the supply of the first gas, the valve 243C is opened to allow the first gas and the second gas to flow through the gas supply pipe 232a simultaneously. A flow rate of the second gas is regulated by the MFC 241C, and the second gas is supplied, along with the first gas, into the process chamber 201, and exhausted via the exhaust pipe 231. At this time, the valve 243e is simultaneously opened to allow the inert gas to flow through the gas supply pipe 232e. A flow rate of the inert gas is regulated by the MFC 241e, and the inert gas is supplied, along with the first and second gases, into the process chamber 201, and exhausted via the exhaust pipe 231. Further, to prevent the first and second gases from entering the nozzle 249b, the valve 243d is opened to allow the inert gas to flow through the gas supply pipe 232d. The inert gas is supplied into the process chamber 201 via the gas supply pipe 232d and the nozzle 249b, and is exhausted via the exhaust pipe 231. At this time, the main gas flowing through the process chamber 201 is the first and second gases.

Processing conditions in step S112 are exemplified as follows:
Simultaneous supply time of first and second gases (period TC): 0.01 to 60 seconds, specifically, 2 to 40 seconds;
Processing pressure: 10 to 13,300 Pa, specifically, 20 to 1,330 Pa;
Supply flow rate of first gas: 0.001 to 1 slm, specifically, 0.2 to 0.9 slm;
Supply flow rate of second gas: 0.1 to 10 sccm, specifically, 1 to 5 sccm; and
Supply flow rate of inert gas: 0.1 to 20 slm, specifically, 1 to 10 slm.

Through the simultaneous supply of the first and second gases, the metal-containing substance Y containing the metal element X is formed on at least a portion of the wafer 200.

In this case, the second gas forms the metal-containing substance Y on the wafer 200. Further, the second gas has a property of etching (also referred to as removing) the metal-containing substance Y on the wafer 200 at a second rate that is higher than the first etching rate of the first gas described above. In addition, the second gas may form the metal-containing substance Y on the wafer 200 at a film formation rate lower than the film formation rate of the first gas described above. In other words, it may be said that the second gas is a gas that is less likely to form the metal-containing substance Y on the wafer 200 and is more likely to remove the metal-containing substance Y on the wafer 200.

For example, a gas containing the above-described metal element X and the above-described halogen element but not containing O may be used as the second gas. The second gas may be a gas constituted by the metal element X and the halogen element. In such a case, it is easier to achieve a higher etching rate with the second gas than with the first gas, making it easier to obtain the effects in the embodiments of the present disclosure. In addition, a gas containing the metal element X, the halogen element, and O may be used as the second gas.

Specifically, for example, a gas containing Mo and Cl may be used as the second gas. Examples of the gas containing Mo and Cl may include a gas including any one of a molybdenum pentachloride (MoCl₅) gas and a molybdenum tetrachloride (MoCl₄) gas, or a gas including one or more of these gases.

In this case, the first gas etches the metal-containing substance Y at a lower rate than the second gas. Therefore, when forming a film on the wafer 200 by using the first gas, the film formation rate may be improved compared to a case where the second gas is used. However, the metal-containing substance Y on the second surface 400 (other than the first surface 300) is less likely to be removed due to the lower etching rate, resulting in reduced selectivity.

On the other hand, the second gas etches the metal-containing substance Y at a higher rate than the first gas. Therefore, when forming the film on the wafer 200 by using the second gas, it is easier to remove the metal-containing substance Y on the second surface 400, resulting in improved selectivity. However, the second gas may cause damage to the surface of the wafer 200 due to etching. Further, in a case where an exposure amount of the second gas to the wafer 200 is decreased, for example, by supplying a larger amount of the gas (e.g., inert gas) other than the second gas to prevent etching by the second gas, the film formation rate on the first surface 300 may also be decreased.

In this case, "damage to the wafer 200" refers to, for example, removal or alteration of the surface of the wafer 200 (for example, one or more of the substances formed on the wafer 200 such as the substance mainly forming the wafer 200, the first substance forming the first surface 300, and the second substance forming the second surface 400).

In step S112, a supply period of the first gas and a supply period of the second gas overlap each other. That is, step S11 includes a period TC during which both the supply of the first gas and the supply of the second gas are performed partially simultaneously. During this period TC, the second gas is supplied to the wafer 200 in addition to the first gas. Therefore, the exposure amount of the second gas to the wafer 200 is decreased. Therefore, damage to the wafer 200 caused by the second gas with a high etching rate may be reduced.

Further, a period T1 during which the first gas is supplied is provided before this step. That is, the second gas is supplied after the first gas is supplied to the wafer 200. In this case, when the supply of the second gas starts in this step, the metal-containing substance Y is formed on at least a portion of the wafer 200 by the first gas. Therefore, damage to the wafer 200 may be prevented.

Further, since the first gas also has a property of forming the metal-containing substance Y on the wafer 200, the film formation rate is less likely to decrease in this step. Accordingly, it is possible to improve the selectivity while preventing a decrease in film formation rate and damage to the wafer 200. Thus, the selective film formation may be performed efficiently.

In this case, the "exposure amount of the second gas" is calculated, for example, as a value obtained by integrating the partial pressure of the second gas in the space where the wafer 200 exists in the process of supplying the second gas over the time from the start to the end of the supply of the second gas (hereinafter, referred to as the "supply time of the second gas"). Further, the "partial pressure of the second gas" is calculated, for example, as a value obtained by integrating, over time, a product of a molar fraction of the second gas and a processing pressure in the space where the wafer 200 exists. The same applies to other gases described below.

### ((Second Gas Supply, Step S113))

After step S112, the supply of the first gas stops while continuing to supply the second gas. That is, the supply of the second gas ends after the supply of the first gas ends. Specifically, the valve 243a is closed to stop the flow of the first gas through the gas supply pipe 232a, but allowing the second gas to flow therethrough. A flow rate of the second gas is regulated by the MFC 241C, and the second gas is supplied into the process chamber 201, and exhausted via the exhaust pipe 231. At this time, the valve 243e is simultaneously opened to allow the inert gas to flow through the gas supply pipe 232e. A flow rate of the inert gas is regulated by the MFC 241e, and the inert gas is supplied along with the second gas into the process chamber 201, and exhausted via the exhaust pipe 231. Further, to prevent the second gas from entering the nozzle 249b, the valve 243d is opened to allow the inert gas to flow through the gas supply pipe 232d. The inert gas is supplied into the process chamber 201 via the gas supply pipe 232d and the nozzle 249b, and is exhausted via the exhaust pipe 231. At this time, the main gas flowing through the process chamber 201 is the second gas.

Processing conditions in step S113 are exemplified as follows:
Supply time of second gas (period T2): 0.01 to 60 seconds, specifically, 2 to 20 seconds;
Processing pressure: 10 to 13,300 Pa, specifically, 20 to 1,330 Pa;
Supply flow rate of second gas: 0.1 to 10 sccm, specifically, 1 to 5 sccm; and
Supply flow rate of inert gas: 0.1 to 20 slm, specifically, 1 to 10 slm.

Through the supply of the second gas, the metal-containing substance Y containing the metal element X is formed on at least a portion of the wafer 200. Supplying the second gas with a high etching rate makes it easier to remove the metal-containing substance Y on the second surface 400. Therefore, the metal-containing substance Y containing the metal element X is formed on the first surface 300 preferentially over the second surface 400 of the wafer 200.

In this way, after the period TC during which the first and second gases are supplied simultaneously in step S112 described above, a period T2 during which the second gas is supplied is provided. This allows for the metal-containing substance Y formed on the second surface 400 during the period TC to be removed during the period T2. That is, in this step, since the metal-containing substance Y is formed even on the second surface 400 during the period TC, damage to the wafer 200 may be prevented even in a case where the second gas with a high etching rate is supplied.

Further, when forming the film 500, which is the metal-containing substance Y, to fill the recess 350, etching tends to proceed more easily on the opening side of the recess 350 than on the bottom side of the recess 350 (i.e., on the first surface 300). Thus, the metal-containing substance Y formed on the second surface 400, which is the sidewall of the recess 350, during the period TC is removed by using the second gas with a low film formation rate and a high etching rate during the period T2. Therefore, it is less likely to form the metal-containing substance Y on the second surface 400, which is the sidewall of the recess 350, which may prevent an occurrence of voids or seams in the film 500 filling the recess 350. In other words, it is possible to facilitate the formation of the metal-containing substance Y on the bottom side of the recess 350 while removing the metal-containing substance Y formed on the second surface 400 within the recess 350, thereby making it possible to balance both the film formation rate and the selectivity.

### (Purge, Step S12)

After the metal-containing substance Y containing the metal element X is formed on at least a portion of the wafer 200, while the valves 243a to 243C are in the closed state, the valves 243d and 243e are opened to supply the inert gas as a purge gas into the gas supply pipes 232a and 232b via the gas supply pipes 232d and 232e. At the same time, while the APC valve 244 of the exhaust pipe 231 remains open, the inside of the process chamber 201 is vacuum-exhausted by the vacuum pump 246, thereby purging the inside of the process chamber 201. At this time, gases or reaction by-products remaining in the process chamber 201 are removed.

### (Reaction Gas Supply, Step S13)

Next, a reaction gas is supplied to the wafer 200 within the process chamber 201. Specifically, the valve 243b is opened to allow the reaction gas to flow through the gas supply pipe 232b. A flow rate of the reaction gas is regulated by the MFC 241b, and the reaction gas is supplied into the process chamber 201 via the nozzle 249b, and exhausted via the exhaust port 231. At this time, the valve 243d is simultaneously opened to allow an inert gas to flow through the gas supply pipe 232d. A flow rate of the inert gas is regulated by the MFC 241d, and the inert gas is supplied along with the reaction gas into the process chamber 201, and exhausted via the exhaust pipe 231. Further, to prevent the reaction gas from entering the nozzle 249a, the valve 243e is opened to allow the inert gas to flow through the gas supply pipe 232e. The inert gas is supplied into the process chamber 201 via the gas supply pipe 232e and the nozzle 249a, and is exhausted via the exhaust pipe 231. At this time, the main gas flowing through the process chamber 201 is the reaction gas.

Processing conditions in step S13 are exemplified as follows:
Supply time of reaction gas: 0.01 to 600 seconds, specifically, 10 to 300 seconds;
Processing pressure: 10 to 26,600 Pa, specifically, 100 to 13,300 Pa;
Supply flow rate of reaction gas: 0.1 to 50 slm, specifically, 10 to 40 slm; and
Supply flow rate of inert gas: 0.1 to 5 slm, specifically, 1 to 3 slm.

Through the supply of the reaction gas, the halogen elements contained in the first gas and the second gas are reduced by the reaction gas, and as illustrated in FIG. 4B, a layer containing the metal element X is formed on at least a portion of the wafer 200, i.e., on the first surface 300 where the metal-containing substance Y that contains the metal element X is formed, preferentially over the second surface 400.

For example, a gas that reacts with the first and second gases and has a reducing property with respect to the first and second gases may be used as the reaction gas. Examples of the reaction gas may include a hydrogen (H₂) gas, deuterium (D₂) gas, borane (BH₃) gas, diborane (B₂H₆) gas, carbon monoxide (CO) gas, ammonia (NH₃) gas, monosilane (SiH₄) gas, disilane (Si₂H₆) gas, trisilane (Si₃H₈) gas, monogermane (GeH₄) gas, and digerman (Ge₂H₆) gas.

Further, in addition to the reducing gas, a gas that reacts with the metal-containing substance Y to form a conductive substance, among gases including, for example, a nitriding gas, a sulfiding gas, a seleniding gas, or a telluriding gas, may be used as the reaction gas. For example, when the first reaction gas is any one of the nitriding gas, the sulfiding gas, the seleniding gas, and the telluriding gas, a nitride film, a sulfide film, a selenide film, or a telluride film may be formed on the wafer.

For example, one or more selected from the group of hydrogen nitride gases such as a NH₃ gas, a diazen (N₂H₂) gas, and a hydrazine (N₂H₄) gas may be used as the nitriding gas. For example, a gas such as a sulfane (H₂S), disulfane (H₂S₂), diammonium sulfide ((NH₄) ₂S), or dimethyl sulfide ((CH₃) ₂S) gas may be used as the sulfiding gas. One or more of these gases may be used as the sulfiding gas. For example, a gas such as a selane (H₂Se), diselane (H₂Se₂), or dimethyl selenide ((CH₃) ₂Se) gas may be used as the seleniding gas. One or more of these gases may be used as the seleniding gas. For example, a gas such as a tellane (H₂Te), ditellane (H₂Te₂), or dimethyl telluride ((CH₃) ₂Te) gas may be used as the telluriding gas. One or more of these gases may be used as the telluriding gas.

### (Purge, Step S14)

Next, the inert gas is supplied as a purge gas by the same processing procedure as in step S12 described above. At the same time, the APC valve 244 of the exhaust pipe 231 remains open, such that the inside of the process chamber 201 is vacuum-exhausted by the vacuum pump 246, thereby purging the inside of the process chamber 201. At this time, gases or reaction by-products remaining in the process chamber 201 are removed.

### (Predetermined Number of Repetitions)

A cycle including the above-described steps S11 to S14 is performed a predetermined number of times (n times, where n is 1 or an integer of 2 or more). As a result, as illustrated in FIG. 4C, the film 500 containing the metal element X with a predetermined thickness is formed on the first surface 300 of the wafer 200, which includes the first surface 300 and the second surface 400, within the recess 350 on the wafer 200, preferentially over the second surface 400.

There are cases where a precursor gas tends to solidify within the process chamber 201 at a temperature below 200 degrees C. Further, a resistivity of the film 500 may increase due to aggregation of the film 500 at a temperature above 650 degrees C. Accordingly, performing the film formation process at a temperature of 200 degrees C or higher and 650 degrees or lower may prevent generation of foreign matters and promote the formation of a low-resistance film. Further, performing the film formation process at a temperature of 300 degrees C or higher and 600 degrees or lower may further prevent generation of foreign matters and promote formation of a lower resistance film. Further, performing the film formation process at a temperature of 350 degrees C or higher and 550 degrees or lower may significantly prevent generation of foreign matters and promote formation of a very low resistance film.

Further, in a case where the film formation process is performed at a temperature of 400 degrees C or lower, the metal-containing substance Y is less likely to be formed from the precursor gas than at a temperature above 400 degrees C. On the other hand, an etchability of the metal-containing substance Y by the precursor gas is less likely to change significantly than at a temperature above 400 degrees C. Therefore, in a case where the film formation process is performed on the wafer 200 by using the precursor gas with a high etchability at a temperature of 400 degrees C or lower, damage to the wafer 200 is likely to increase while the film formation process sufficiently progresses. In the technique of the present disclosure, by simultaneously supplying multiple precursor gases with different etchabilities during the period TC, it is possible to perform film formation with good selectivity while preventing damage to the wafer 200 even in a case where the film formation process is performed at a temperature of 400 degrees C or lower.

The film 500 containing the metal element X is a film made of a conductive substance. For example, a metal-containing film that contains the metal element X is formed as the film made of a conductive substance. Examples of the metal-containing film may include a Mo-containing film.

### (After Purge and Returning to Atmospheric Pressure)

The inert gas is supplied into the process chamber 201 from each of the gas supply pipes 232d and 232e, and is exhausted via the exhaust pipe 231. The inert gas functions as a purge gas. As a result, the inside of the process chamber 201 is purged, and any gases and reaction by-products remaining within the process chamber 201 are removed from the inside of the process chamber 201 (after-purge). Thereafter, the internal atmosphere of the process chamber 201 is substituted with the inert gas (inert gas substitution), and the internal pressure of the process chamber 201 is returned to a normal pressure (returning to atmospheric pressure).

### (Wafer Unloading)

The seal cap 219 is lowered by the boat elevator 115 to open the lower end of the manifold 209. Then, the processed wafer 200 is unloaded from the lower end of the manifold 209 to the outside of the reaction tube 203 while being supported by the boat 217 (boat unloading). The processed wafer 200 is discharged from the boat 217 (wafer discharging).

### (3) Other Embodiments

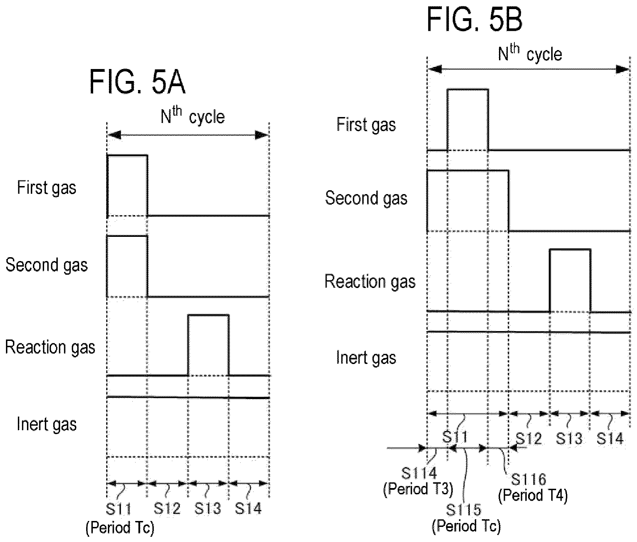

Next, modifications of the film formation process according to the above-described embodiments will be described in detail. The following modification describes differences from the above-described embodiments. FIGS. 5A and 5B illustrate the difference in timing between the first gas supply and the second gas supply in the precursor gas supply step S11 of the film formation process described above.

### (First Modification)

In this modification, as illustrated in FIG. 5A, during one cycle of the film formation process, the supply of the first gas and the supply of the second gas start simultaneously and also end simultaneously. That is, this modification includes the period TC, during which both the first gas and the second gas are supplied simultaneously, in one cycle of the film formation process.

This modification also provides at least a part of the same effects as those in the above-described embodiments. For example, it is possible to improve selectivity while preventing a decrease in film formation rate and damage to the wafer 200. Accordingly, selective film formation may be performed efficiently. Further, in this modification, it is possible to shorten the processing time, thus improving throughput.

### (Second Modification)

In this modification, as illustrated in FIG. 5B, during one cycle of the film formation process, the supply of the second gas starts before the start of the supply of the first gas, and the supply of the second gas ends after the end of the supply of the first gas. In other words, the supply of the first gas starts and the supply of the first gas ends during the supply of the second gas. In other words, in this modification, one cycle of the film formation process includes the period TC during which both the first gas and the second gas are supplied simultaneously (step S115), with a period T3 during which the second gas is supplied (step S114) before the period TC (step S115), and a period T4 during which the second gas is supplied (step S116) after the period TC (step S115).

This modification also provides at least a part of the same effects as those in the above-described embodiments. That is, it is possible to improve selectivity while preventing a decrease in film formation rate and preventing damage to the wafer 200. Thus, selective film formation may be performed efficiently. Further, in this modification, since the second gas with a high etching rate is supplied before the start of the supply of the first gas, it is possible to supply the first gas in a state where the metal-containing substance Y is less likely to remain on the second surface 400. Therefore, it is possible to prevent further growth of the metal-containing substance Y formed on the second surface 400, thereby further improving selectivity.

Further, the supply of the second gas may be started before the start of the supply of the first gas, and the supply of the second gas may be ended before the end of the supply of the first gas, during one cycle of the film formation process. Even in such a case, at least a part of the same effects as those in the above-described embodiments may be obtained.

### (Third Modification)

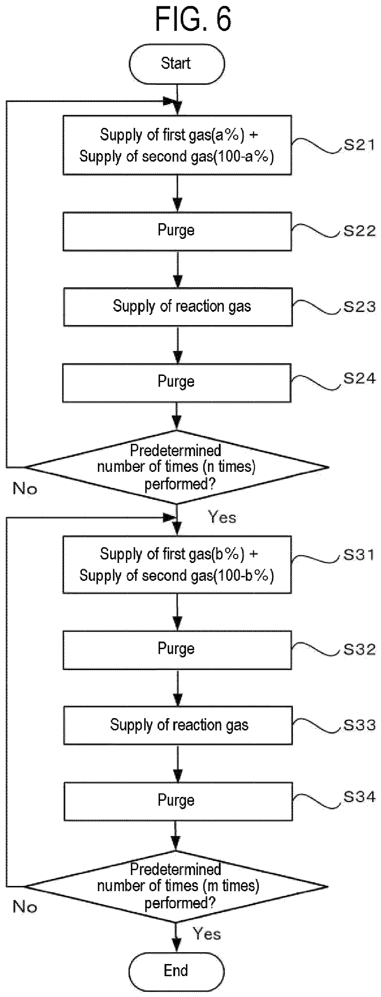

In this modification, as illustrated in FIG. 6, a first film formation process, in which step S21 of simultaneously supplying a% of the first gas and (100-a)% of the second gas, step S22 of performing purge in the same manner as the above-described step S12, step S23 of supplying the reaction gas in the same manner as the above-described step S13, and step S24 of performing purge in the same manner as the above-described step S14 are performed a predetermined number of times (n times, where n is 1 or an integer of 2 or more), is performed, and thereafter, a second film formation process, in which step S31 of simultaneously supplying b% of the first gas and (100-b)% of the second gas, step S32 of performing purge in the same manner as the above-described step S12, step S33 of supplying the reaction gas in the same manner as the above-described step S13, and step S34 of performing purge in the same manner as the above-described step S14 are performed a predetermined number of times (m times, where m is 1 or an integer of 2 or more), is performed. Here, a and b are integers between 0 and 100, and a and b are different numbers.

In this case, in steps S21 and S31, a% or b% refer to a ratio of an amount (e.g., a flow rate, a molecular count, or an exposure amount per hour) of the first gas or the second gas to a total of the amounts of the first gas and the second gas supplied to the wafer 200, respectively. In this case, a and b are integers between 0 and 100. Herein, in a case where a or b is 0, it means that no first gas is supplied in the first film formation process or the second film formation process. Further, in a case where a or b is 100, it means that no second gas is supplied in the first film formation process or the second film formation process. The same applies to the following description. In the following description, the first film formation process when a is 100 is referred to as a third film formation process, and the second film formation process when b is 100 is referred to as a fourth film formation process.

In addition, the above-described embodiments or the second modification may be combined with each of the first film formation process, the second film formation process, and the fourth film formation process. For example, before at least one selected from the group of steps S21 and S31, the first gas or the second gas may be supplied, like steps S111 and S114. Further, before at least one selected from the group of steps S21 and S31, the second gas may be supplied, like steps S113 and S116. Further, the first gas may be supplied after at least one selected from the group of step S21 and step S31. That is, in the first film formation process, the second film formation process, and the fourth film formation process, the supply of the first gas and the supply of the second gas to the wafer 200 may be performed at least partially simultaneously during a certain period TC'. Even in such a case, at least a part of the above-described effects are obtained.

The second film formation process or the fourth film formation process on the wafer 200 may be performed under a condition in which the metal-containing substance Y is more likely to be removed than in the first film formation process or the third film formation process. In this case, since the metal-containing substance Y on the wafer 200 is less likely to be removed in the first film formation process or the third film formation process, it is possible to improve the film formation rate while preventing damage to the wafer 200 due to the precursor gas. Then, it is possible to prevent damage to the wafer 200 since the second film formation process or the fourth film formation process may be performed in a state where the metal-containing substance Y is formed on the wafer 200. Further, in the second film formation process or the fourth film formation process, since the metal-containing substance Y formed on the second surface 400 is likely to be removed, it is possible to improve selectivity. Accordingly, the modifications may result in improved selectivity and a higher film formation rate while preventing damage to the wafer 200.

For example, it is acceptable to set b<a. Specifically, a ratio R2 (corresponding to an example of b%) of the flow rate of the first gas to a total of the flow rates of the first gas and the second gas supplied to the wafer 200 during the period TC' in the second film formation process may be less than a ratio R1 (corresponding to an example of a%) during the period TC' in the first film formation process. Further, the exposure amount of the first gas to the wafer 200 in step S31 of the second film formation process may be less than the exposure amount of the first gas to the wafer 200 in step S21 of the first film formation process. Further, the exposure amount of the second gas to the wafer 200 in step S31 of the second film formation process may be more than the exposure amount of the second gas to the wafer 200 in step S21 of the first film formation process. For example, by performing the second film formation process so as to satisfy at least one of these conditions, it is possible to perform the second film formation process under a condition in which the metal-containing substance Y is less likely to be formed on the wafer 200 than in the first film formation process, in other words, under a condition in which the metal-containing substance Y on the wafer is more likely to be removed.

More specifically, the supply time of the second gas in the second film formation process may be longer than the supply time of the first gas in the first film formation process. Further, the supply flow rate of the second gas in the second film formation process may be higher than the supply flow rate of the first gas in the first film formation process. Further, the flow rate of the inert gas supplied simultaneously with the second gas in the second film formation process may be lower than the flow rate of the inert gas supplied simultaneously with the first gas in the first film formation process. For example, by satisfying at least one of these conditions, it is possible to make the exposure amount of the first gas to the wafer 200 in step S31 of the second film formation process smaller than the exposure amount of the first gas to the wafer 200 in step S21 of the first film formation process, or to make the exposure amount of the second gas to the wafer 200 in step S31 of the second film formation process greater than the exposure amount of the second gas to the wafer 200 in step S21 of the first film formation process.

Further, the above-described embodiments and the first to third modifications are described by using the case where the precursor gas supply and the reaction gas supply are performed alternately in a non-simultaneous manner in the film formation process. The present disclosure is not limited to the above-described embodiments, and the precursor gas supply (i.e., the first gas supply and the second gas supply) and the reaction gas supply may be performed at least partially simultaneously. Even in such a case, at least a part of the same effects as those in the above-described embodiments may be obtained.

Further, the above-described embodiments and the first and third modifications are described by using the case where the first gas and the second gas are supplied from the same nozzle 249a. The present disclosure is not limited to the above-described embodiments, and the first gas and the second gas may be supplied from different nozzles. Even in such a case, at least a part of the same effects as those in the above-described embodiments may be obtained.

Further, the above-described embodiments and the first to third modifications are described by using the example in which a film is formed by using a batch-type substrate processing apparatus configured to process a plurality of substrates at once. The present disclosure is not limited to the above-described embodiments, and may also be suitably applied, for example, to a case where a film is formed by using a single-wafer-type substrate processing apparatus configured to process one or several substrates at a time. Further, the above-described embodiments describes the example in which a film is formed by using a substrate processing apparatus including a hot-wall-type process furnace. The present disclosure is not limited to the above-described embodiments, and may also be suitably applied to a case where a film is formed by using a substrate processing apparatus including a cold-wall-type process furnace.

When using these processing apparatuses as well, it is possible to perform each processing by using the same processing procedures and processing conditions as in the above-described embodiments and modifications, thereby achieving the same effects as in the above-described embodiments and modifications.

The above-described embodiments and the first to third modifications may be used in appropriate combinations. The processing procedure and processing condition at this time may be the same as the processing procedures and processing conditions in the above-described embodiments and modifications, for example.

The embodiments and modifications of the present disclosure are specifically described above. However, the present disclosure is not limited to the above-described embodiments and modifications, and may be changed in various ways without departing from the scope of the present disclosure.

According to the present disclosure, it is possible to efficiently perform selective film formation.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate, comprising:
performing a film formation operation of forming a film containing a metal element on a first surface preferentially over a second surface of a substrate, the act of performing the film formation operation including:
(a) forming a metal-containing substance that contains the metal element on at least a portion of the substrate by performing:
(a1) supplying a first gas containing the metal element to the substrate including the first surface that is a surface of a first substance and the second surface that is a surface of a second substance different from the first substance; and
(a2) supplying a second gas containing the metal element to the substrate; and
(b) supplying a reaction gas to the substrate,
wherein (a) includes a period TC during which (a1) and (a2) are performed simultaneously,
wherein the first gas etches the metal-containing substance at a first rate, and
wherein the second gas etches the metal-containing substance at a second rate higher than the first rate.

2. The method of Claim 1, wherein (a2) ends after (a1) ends.

3. The method of Claim 1 or 2, wherein (a2) starts after (a1) starts.

4. The method of Claim 1 or 2, wherein (a2) starts before (a1) starts.

5. The method of any one of Claims 1 to 4, further comprising:
performing a first film formation operation of performing the film formation operation;
and
performing a second film formation operation of performing the film formation operation on the substrate, under a condition in which the metal-containing substance is more likely to be removed than in the first film formation operation, after the first film formation operation.

6. The method of Claim 5, wherein, in the second film formation operation, during the period TC, a ratio R2 of a flow rate of the first gas to a total flow rate of the first gas and the second gas supplied to the substrate is smaller than a ratio R1 of a flow rate of the first gas to a total flow rate of the first gas and the second gas supplied to the substrate in the first film formation operation.

7. The method of Claim 5, wherein an exposure amount of the first gas to the substrate in (a1) of the second film formation operation is smaller than an exposure amount of the first gas to the substrate in (a1) of the first film formation operation.

8. The method of Claim 5, wherein an exposure amount of the second gas to the substrate in (a2) of the second film formation operation is greater than an exposure amount of the second gas to the substrate in (a2) of the first film formation operation.

9. The method of any one of Claims 1 to 8, further comprising:
performing a third film formation operation in which (a1) and (b) are performed but (a2) is not performed; and
performing a fourth film formation operation of performing the film formation operation after the third film formation operation.

10. The method of any one of Claims 1 to 9, wherein a gas containing the metal element, a halogen element, and oxygen is used as the first gas.

11. The method of any one of Claims 1 to 10, wherein a gas, which contains the metal element and a halogen element but does not contain oxygen, is used as the second gas.

12. The method of any one of Claims 1 to 11, wherein the film formation operation is performed at a temperature of 200 degrees C or higher and 650 degrees C or lower.

13. A method of manufacturing a semiconductor device, comprising the method of Claim 1.

14. A substrate processing apparatus comprising:
a gas supply system configured to supply a first gas containing a metal element, a second gas containing the metal element, and a reaction gas, respectively; and
a controller configured to be capable of controlling the gas supply system, so as to perform a process comprising:
performing a film formation operation of forming a film containing the metal element on a first surface preferentially over a second surface of a substrate, the act of performing the film formation operation including:
(a) forming a metal-containing substance that contains the metal element on at least a portion of the substrate by performing:
(a1) supplying the first gas to the substrate including the first surface that is a surface of a first substance and the second surface that is a surface of a second substance different from the first substance; and
(a2) supplying the second gas to the substrate; and
(b) supplying the reaction gas to the substrate,
wherein (a) includes a period TC during which (a1) and (a2) are performed simultaneously, and
wherein the gas supply system supplies, as the first gas, a gas that etches the metal-containing substance at a first rate, and, as the second gas, a gas that etches the metal-containing substance at a second rate higher than the first rate.

15. A program that causes, by a computer, a substrate processing apparatus to perform a process comprising:
performing a film formation operation of forming a film containing a metal element on a first surface preferentially over a second surface of a substrate, the act of performing the film formation operation including:
(a) forming a metal-containing substance that contains the metal element on at least a portion of the substrate by performing:
(a1) supplying a first gas containing the metal element to the substrate including the first surface that is a surface of a first substance and the second surface that is a surface of a second substance different from the first substance; and
(a2) supplying a second gas containing the metal element to the substrate; and
(b) supplying a reaction gas to the substrate,
wherein (a) includes a period TC during which (a1) and (a2) are performed simultaneously,
wherein the first gas etches the metal-containing substance at a first rate, and
wherein the second gas etches the metal-containing substance at a second rate higher than the first rate.
